(19) Europäisches Patentamt
European Patent Office
Office européen des brevets

(11) **EP 2 554 368 A1**

(12) **EUROPEAN PATENT APPLICATION**
published in accordance with Art. 153(4) EPC

(43) Date of publication:
**06.02.2013 Bulletin 2013/06**

(51) Int Cl.:
**B32B 9/00** (2006.01)   **C23C 14/48** (2006.01)
**H01L 31/042** (2006.01)

(21) Application number: **11762770.3**

(22) Date of filing: **28.03.2011**

(86) International application number:
**PCT/JP2011/057608**

(87) International publication number:
**WO 2011/122546 (06.10.2011 Gazette 2011/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.03.2010 JP 2010075107**

(71) Applicant: **LINTEC Corporation
Tokyo 173-0001 (JP)**

(72) Inventors:
• **SUZUKI Yuta
Tokyo 173-0001 (JP)**
• **KONDO Takeshi
Tokyo 173-0001 (JP)**

(74) Representative: **Albrecht, Thomas
Kraus & Weisert
Patent- und Rechtsanwälte
Thomas-Wimmer-Ring 15
80539 München (DE)**

(54) **MOLDED ARTICLE, METHOD FOR PRODUCING THE SAME, ELECTRONIC DEVICE MEMBER, AND ELECTRONIC DEVICE**

(57)   Provided is a formed article comprising at least a gas barrier layer, the gas barrier layer being formed of a material that includes silicone atoms, oxygen, atoms, and carbon atoms, a carbon atom content, a silicon atom content, and an oxygen atom content in a surface layer part of the gas barrier layer determined by XPS elemental analysis being 10.0 to 28.0%, 18.0 to 28.0%, and 48.0 to 66.0°%, respectively, based on a total content (=100 atom%) of silicon atoms, oxygen atoms, and carbon atoms, and the formed article having a water vapor transmission rate at a temperature of 40°C and a relative humidity of 90% of 5.3 g/m$^2$/day or less, and a total light transmittance at a wavelength of 550 nm 90% or more. Also provided are a method for producing the formed article, an electronic device member including the formed article, and an electronic device including the electronic device member. The formed article exhibiting an excellent gas barrier capability, excellent flexibility, and excellent transparency, a method for producing the same, and an electronic device member, or the like, comprising the formed article are provided.

FIG.1

(a)

(b)

EP 2 554 368 A1

**Description**

TECHNICAL FIELD

The invention relates to a formed article, a method for producing the same, an electronic device member that includes the formed article, and an electronic device that includes the electronic device member.

BACKGROUND ART

In recent years, a solar cell has attracted attention as a clean energy source. A solar cell module normally includes a glass plate, an electrode, a photoconversion layer, an electrode, and a back side protective sheet from the light-receiving side.
For example, Patent Document 1 discloses a solar cell module protective sheet (back side protective sheet) produced by depositing an inorganic oxide film on one side or a heat-resistant substrate, and stacking a coloured polyester resin layer on the inorganic oxide layer, Patent Document 2 discloses a solar cell back side protective sheet formed of a fluororesin sheet having a thickness of 30 µm or less, and Patent Document 3 discloses an electric/electronic insulating sheet (back side protective sheet) in which an aziridinyl group-containing adhesive, resin layer is formed on at least one side of a fluorine-based film formed of a fluorine-containing resin and a resin that does not contain fluorine.
However, since these sheers and films have an insufficient water vapor barrier capability, the electrodes and the photoconversion layer may deteriorate, or the glass plate may break due to an external impact.
A plastic substrate has been increasingly used for image display devices instead of a glass substrate in order to achieve a reduction in weight, an increase in flexibly, a reduction in cost, and the like.
A plastic film has a problem in that the plastic film has a high gas permeability. Patent Document 4 discloses a method that improves the gas barrier capability of a plastic film by providing a metal or a metal oxide on a substrate.
However, since a flexible device is normally bent, held with the hand, or pressed, cracks and the like easily occur in such an inorganic film.
Patent Document 5 discloses technology that improves the gas barrier capability of diamond-like carbon (DLC) by performing a plasma ion implantation treatment on an organic compound.
When using the technology disclosed in Patent Document 5, however, the gas barrier capability is not sufficient for protecting a display device from moisture. Moreover, since the transparency of the DLC layer significantly decreases, it is difficult to apply the technology disclosed in Patent Document 5 to a display device.

RELATED-ART DOCUMENT

PATENT DOCUMENT

Patent Document 1: JP-A-2001-119051
Patent Document 2: JP-A-2003-347570
Patent Document 3: JP-A-2004-352966
Patent Document 4: JP-A-10-305542
Patent Document 5: JP-A-2007-283726

SUMMARY OF THE INVENTION

TECHNICAL PROBLEM

The invention was conceived in view of the above situation. An object of the invention is to provide a formed article that exhibits an excellent gas barrier capability, excellent flexibility, mid excellent transparency, a method for producing the same, an electronic device member that includes the formed article, and an electronic device that includes the electronic device member.

SOLUTION TO PROBLEM

The inventors of the invention conduced expensive studies in order to achieve the above object, and found that a formed article that includes at least a gas barrier layer that is formed of a material that includes silicon atoms, oxygen atoms, and carbon atoms in a given ratio, exhibits an excellent gas barrier capability, excellent flexibility, and excellent transparency. The inventors also found that the gas barrier layer of the formed article can be conveniently and efficiently formed by implanting ions into a layer that includes a hydrolysis/dehydration-condensation product of a tetrafunctional organosilane compound (e.g., tetraethoxysilane). These findings have led to the completion of the invention.

Several, aspects of the invention provide the following formed article (see (1) to (6)), method for producing a formed article (see (7) to (10)), electronic device member (see (11)), and electronic device (see (12)).

(1) A formed article including at least a gas barrier layer,
the gas barrier layer being formed of a material that includes silicon atoms, oxygen atoms, and carbon atoms, a carbon atom content, a silicone atom content, and an oxygen atom content in a surface layer part of the gas barrier layer determined by XPS elemental analysis being 10.0 to 28.0%, 18.0 to 28.0%, and 48.0 to 66.0%, respectively, based on a total content (=100 atom%) of silicon atoms, oxygen atoms, and carbon atoms, and
the formed article having a water vapor transmission rate at a temperature of 40°C and a relative humidity of 90% of 5.3 $g/m^2/day$ or less, and a total light transmittance at a wavelength of 550 nm of 90% or more.
(2) A formed article including an ion-implanted layer that is obtained by implanting ions into a layer that includes a hydrolysis/dehydration-condensation product of a tetrafunctional organosilane compound.
(3) The formed article according to (2), wherein the ions are obtained by ionizing at least one gas selected from a group consisting of hydrogen, oxygen, nitrogen, argon, helium, neon, xenon, krypton, a silicon compound, and a hydrocarbon.
(4) The formed article according to (2) or (3), wherein the ion-implanted layer is a layer obtained by implanting the ions into the layer that includes the hydrolysis/dehydration-condensation product of the tetrafunctional organosilane compound by a plasma ion implantation method.
(5) The formed article according to (2) or (3), wherein the tetrafunctional organosilane compound is a tetra($C_1$-$C_{10}$) alkoxysilane.
(6) A method for producing the termed article according to (2) or (3), the method including implanting ions into a surface area a layer that is included in a formed body and includes a hydrolysis/dehydration-condensation product or a tetrafunctional organosilane compound, the formed body including the layer that includes the hydrolysis/dehydration-condensation product of the tetrafunctional organosilane compound in a surface area.
(7) The method according to (6), including implanting ions of at least one gas selected from a group consisting of hydrogen, nitrogen, oxygen, argon, helium, neon, xenon, krypton, a silicon compound, and a hydrocarbon into a layer that is included in a formed body and includes a hydrolysis/dehydration-condensation produce of a tetrafunctional organosilane compound, the formed body including the layer that includes the hydrolysis/dehydration-condensation produce of the tetrafunctional organosilane compound in a surface area.
(8) The method according to (6), including implanting ions of at least one gas selected from a group consisting of hydrogen, nitrogen, oxygen, argon, helium, neon, xenon, krypton, a silicon compound, and a hydrocarbon into a layer that is included in a formed body and includes a hydrolysis/dehydration-condensation product of a tetrafunctional organosilane compound by a plasma ion implantation method, the formed body including the layer that includes the hydrolysis/dehydration-condensation product of the tetrafunctional organosilane compounds in a surface area.
(9) The method according to (6), including implanting ions into a layer that is included in a long formed body and include a hydrolysis/dehydration-condensation product of a tetrafunctional organosilane compound while feeding the long formed article in a given direction, the long formed body including the layer that includes the hydrolysis/dehydration-condensation product of the tetrafunctional organosilane compound in a surface area.
(10) An electronic device member including the formed article according to any one of (1) to (3).
(11) An electronic device including the electronic device member according to (10).

ADVANTAGEOUS EFFECTS OF THE INVENTION

The formed article according to one aspect of the invention exhibits an excellent gas barrier capability, excellent flexibility, and excellent transparency.
Therefore, the formed article may suitably be used as an electronic device member (e.g., solar cell back side protective sheet) for flexible displays, solar cells, and the like.
The method for producing a formed article according to one aspect of the invention can conveniently and efficiently produce the formed article according to one aspect of the invention that exhibits an excellent gas barrier capability, excellent transparency, and excellent bending resistance. Moreover, an increase in area of the formed article can be easily achieved at low cost as compared with the case of depositing an inorganic film.
The electronic device member according to one aspect of the invention exhibits an excellent gas barrier capability, excellent transparency, and excellent bending resistance, and may suitably be used for electronic devices such as displays and solar cells.

BRIEF DESCRIPTION OF DRAWINGS

FIG. 1 is a view illustrating a schematic configuration of a plasma ion implantation apparatus.
Fig. 2 is a view illustrating a schematic configuration of a plasma ion implantation apparatus.

DESCRIPTION OF EMBODIMENTS

To formed article, a method for producing a formed article, an electronic device member, and an electronic device according to embodiments of the invention are described in detail below.

1) Formed article

A formed article according to first embodiment of the invention includes at least a gas barrier layer, the gas barrier layer being formed of a material that includes silicon atom, oxygen atoms, and carbon atoms, a carbon atom content, a silicon atom content, and an oxygen atom content in a surface layer part of the gas barrier layer determined by XPS elemental analysis being 10.0 to 28.0%, 18.0 to 28.0%, and 48.0 to 66.0%, respectively, based on a total content (=100 atoms%) of silicon atoms, oxygen atoms, and carbon atoms, and the formed article having a water vapor transmission rate at a temperature of 40°C and a relative humidity of 90% of 5.3 $g/m^2$/day or less, and a total light transmittance at a wavelength of 550 nm of 90% or more (hereinafter referred to as "formed article (1)").
Since the formed article (1) includes the gas barrier layer that includes silicone atoms, oxygen atoms, and carbon atoms in the surface layer part within the above range, the formed article (1) exhibits am excellent gas barrier capability, excellent flexibility, and excellent transparency.
Note that the term "surface layer part" of the gas barrier layer used herein refers to an area of the gas barrier layer up to a depth of 1 am from the surface of the gas barrier layer. The term "surface" of the gas barrier layer used herein is intended to include the interlace (boundary surface) with another layer.
In the formed article (1), it is preferable that the carbon atom content, the silicon atom content, and the oxygen atom content in the surface layer part of the gas barrier layer determined by XPS elemental analysis be 12 to 28%, 19 to 28%, and 50 to 64%, and more preferably 12 to 21%, 19 to 26%, and 59 to 64%, respectively, based on the total content (=100 atom%) of silicon atoms, oxygen, atoms, and carbon atoms.
A formed article according to second embodiment of the invention includes an ion-implanted layer that is obtained by implanting ions into a layer that includes a hydrolysis/dehydration-condensation product of a tetrafunctional organosilane compound (hereinafter may be referred to as "silicate layer") (hereinafter referred to as "formed article (2)").
It suffices that the ion-implanted layer included in the formed article (2) be obtained by implanting ions into the silicate layer. It is preferable that the carbon atom content, the silicon atom content, and the oxygen atom content in the surface layer part of the ion-implanted layer determined by XPS elemental analysis be 12.0 to 27.0%, 19.0 to 24.7%, and 50.0 to 63.3%, respectively, based on the total content (=100 atom%) of silicon atoms, oxygen atoms, and carbon atoms.
The silicate layer includes the hydrolysis/dehydration-condensation product of the tetrafunctional organosilane compound. The content of the hydrolysis/dehydration-condensation product of the tetrafunctional organosilane compound in the silicate layer is preferably 50 wt% or more, and more preferably 70 wt% or more, from the viewpoint of obtaining an ion-implanted layer that exhibits an excellent gas barrier capability and excellent transparency.
The tetrafunctional organosilane compound used in connection, with the invention is a compound in which four hydrolyzable groups are bonded to a silicon atom, and is shown by the following formula (A): $SiX_4$.
X in the formula (A) represents a hydrolyzable substituent, and may be either identical or different.
Examples of the substituent represented by X include a group shown by OR (wherein R represents a hydrocarbon group having 1 to 10 carbon atoms or an alkoxy group), a group shown by $OSi(R^a)(R^b)(R^c)$ (therein $R^a$, $R^b$, and $R^c$ independently represent a hydrogen atom, an alkyl group having 1 to 10 carbon atoms, or a phenyl group), a halogen atom, and the like.
Specific examples of the group shown by OR includes alkoxy groups having 1 to 10 carbon atoms ($C_1$-$C_{10}$) such as a methoxy group, an ethoxy group, a propoxy group, an isopropoxy groups, a butoxy group, ain isobutoxy group, a t-butoxy group, a pentyloxy group, and a hexyloxy group; alkoxyalkoxy group having 2 to 10 carbon atoms such as a methoxymethoxy group, an ethoxymethoxy group, and an ethoxyethoxy group; and the like.
Specific Examples of the group shown by $OSi(R^a)(R^b)(R^c)$ includes a silyloxy group, a trimethylsilyloxy group, a triethylsilyloxy group, a phenyldimethylsilyloxy croup, a t-butyldimethylsilyloxy group, and the like.
Examples of the halogen atom include a chloride atom, a bromine atom, and the like.
Specific examples or the tetrafunctional organosilane compound include tetra($C_1$-$C_{10}$)alkoxysilanes such as tetramethoxysilane, tetraethoxysilane, tetrapropoxysilane, tetraisopropoxysilane, and tetrabutoxysilane; tri($C_1$-$C_{10}$)

alkoxyhalogenosilanes such as trimethoxychlorosilane, triethoxychlorosilane, and tripropoxychlorosilane; di($C_1$-$C_{10}$)di-halogenoalkoxysilanes such as dimethoxydichlorosilane, diethoxydichlorosilane, and dipropoxydichlorosilane; mono ($C_1$-$C_{10}$alkoxytrihalogenosilanes such as methoxytrichlorosilane, ethoxytrichlorosilane, and propoxytrichlorosilane; and tetrahalogenosilanes such as tetrachlorosilane and tetrabromosilane. Note that the expression "($C_1$-$C_{10}$)'" means that the number of carbon atoms is 1 to 10.

These tetrafunctional organosilane compounds may be used either alone or in combination.

It is preferable to use tetra($C_1$-$C_{10}$)alkoxysilanes due to an excellent handling capability and a capability to form an ion-implanted layer that exhibits an excellent gas barrier capability, excellent flexibility, and excellent transparency.

The hydrolysis/dehydration-condensation product of the tetrafunctional organosilane compound may be obtained by subjecting the tetrafunctional organosilane compound to hydrolysis/dehydration-condensation in an appropriate solvent in the presence of water and an optional catalyst.

The amount of water is determined so that the ratio of the molar equivalent of water ($H_2O$) to the molar equivalent of the hydrolyzable group (X) (i.e., molar ratio ([$H_2O$]/[X])) is preferably 1.0 or more, and more preferably 1.0 to 5.0. If the molar ratio ([$H_2O$]/[X]) is less than 1.0, the amount of unreacted hydrolyzable group may increase, so that the refractive index of the resulting cured film may increase. If the molar ratio ([$H_2O$]/[X]) is exceeds 5.0, the condensation reaction may proceed to an excessive extent, so that gelation may occur.

The catalyst is not particularly limited. An acidic catalyst or a basic catalyst may be used as the catalyst. Examples of the acidic catalyst include organic acids such as acetic acid, chloroacetic acid, citric acid, benzoic acid, dimethylmalonic acid, formic acid, propionic acid, glutaric acid, glycolic acid, maleic acid, malonic acid, toluenesulfonic acid, and oxalic acid; inorganic acids such as hydrochloric acid, nitric acid, sulfuric acid, phosphoric acid, and halogenated silanes; acidic sol fillers such as acidic colloidal silica and titania sol; and the like. These acidic catalysts may be used either alone or in combination.

Examples of the basic catalyst include alkali metal hydroxides such as sodium hydroxide and potassium hydroxide; alkaline-earth metal hydroxides such as calcium hydroxide; aqueous ammonia; amines such as triethylamine, diisopropylethylamine, and pyridine; and the like. These basic catalysts may be used either alone or in combination. It is preferable to use the acidic catalyst from the viewpoint to reduce the time required for the production process.

The tetrafunctional organosilane compound may be subjected to hydrolysis/dehydration-condensation while optionally heating the reaction apparatus. In particular, the amount of unreacted hydrolyzable group can be infinitely reduced by promoting the hydrolysis reaction at 40 to 100°C over 2 to 100 hours. If the tetrafunctional organosilane compound is hydrolyzed under conditions outside the above temperature range and time range, the hydrolyzable group may remain unreacted.

The weight average molecular weight of the hydrolysis/dehydration-condensation product of the tetrafunctional organosilane compound is not particularly limited, but is preferably 200 to 50,000, and more preferably 200 to 2000, in order to obtain a silicate layer that also exhibits high mechanical strength. If the weight average molecular weight of the hydrolysis/dehydration-condensation product is less than 200, the film-forming capability may deteriorate. If the weight average molecular weight of the hydrolysis/dehydration-condensation product exceeds 2000, the mechanical strength of the cured film may deteriorate.

The silicate layer may include an additional component other than the hydrolysis/dehydration-condensation product of the tetrafunctional organosilane compound as long as the object of the invention is not impaired. Examples of the additional component include an additional polymer, a curing agent, an aging preventive, a light stabilizer, a flame retardant, a filler, a pigment, a leveling agent, an antifoaming agent, an antistatic agent, a UV absorber, a pH-adjusting agent, a dispersant, a surface modifier, a plasticizer, a siccative, an antirunning agent, and the like.

The silicate layer may be formed by applying a silicate layer-forming solution to an appropriate base layer using a known coating method, and appropriately drying the resulting film.

Examples of the silicate layer-forming solution include (a) a solution that includes the tetrafunctional organosilane compound, water, a catalyst, a solvent, and an optional additional component, (b) a solution that includes a (partial) hydrolyzate of the tetrafunctional organosilane compound, water, a catalyst, a solvent, and an optional additional component, (c) a solution that includes a hydrolysis/(partial) dehydration-condensation product of the tetrafunctional organosilane compound, water, a catalyst, a solvent, and an optional additional component, and the like.

It is preferable to use a solvent that stably dissolves the tetrafunctional organosilane compound, the (partial) hydrolyzate of the tetrafunctional organosilane compound, and the hydrolysis/partial) dehydration-condensation product of the tetrafunctional organosilane compound.

Examples of such a solvent include xylene, toluene, esters such as butyl carbitol acetate, n-butyl acetate, and ethyl acetate; glycol ethers such as cellosolve and cellosolve acetate, ketones such as acetone and methyl ethyl ketone, a mixed solvent of two or more of these compounds, and the like.

The content of the solvent in the silicate layer-forming solution is determined depending on the coating method, the type of the tetrafunctional organosilane compound, and the like, but is normally 5 to 99 mass%, and preferably 5 to 60 mass%.

A spin coaster, a knife coater, a gravure coater, or the like may be used to apply the silicate layer-forming solution.

It is preferable to heat the resulting film in order to dry the film, and improve the gas barrier capability of the resulting formed article. In this case, the film is heated at 80 to 150°C for several tens of seconds to several tens of minutes. A hydrolysis/dehydration-condensation reaction of the tetrafunctional organosilane compound, the (partial) hydrolyzate of the tetrafunctional organosilane compound, or the hydrolysis/(partial) dehydration-condensation product of the tetrafunctional organosilane compound proceeds sufficiently as a result of heating the film, so that a high-quality cured film can be formed.

The thickness of the silicate layer is not particularly limited, but is normally 20 nm to 100 μm, preferably 30 nm to 500 nm, and more preferably 40 nm to 200 nm.

According to one embodiment of the invention, the formed article (2) that exhibits a sufficient gas barrier capability can be obtained even if the silicate layer has a thickness at a nanometer level.

The formed article (2) according to one embodiment of the invention includes the ion-implanted layer that is obtained by implanting ions into the silicate layer that is formed as described above.

Examples of the ions implanted into the silicate layer include ions of a rare gas (e.g., argon, helium, neon, krypton, and xenon), a fluorocarbon, hydrogen, nitrogen, oxygen, carbon dioxide, chlorine, fluorine, sulfur, a silicon compound, and a hydrocarbon; ions of a conductive metal (e.g., gold, silver, copper, platinum, nickel, palladium, chromium, titanium, molybdenum, niobium, tantalum, tungsten, and aluminum); and the like.

Among these, ions obtained by ionizing at least one gas selected from the group consisting of hydrogen, nitrogen, oxygen, argon, helium, neon, xenon, krypton, a silicon compound, and a hydrocarbon are preferable due to ease of implantation and a capability to form an ion-implanted layer that exhibits an excellent gas barrier capability and excellent transparency.

Examples of the silicon compound include silane ($SiH_4$) and organosilicon compounds. Examples of the organosilicon compounds include tetraalkoxysilanes such as tetramethoxysilane, tetraethoxysilane, tetra-n-propoxysilane, tetraisopropoxysilane, tetra-n-butoxysilane, and tetra-t-butoxysilane; substituted or unsubstituted alkylalkoxysilanes such as dimethyldimethoxysilane, dimethyldiethoxysilane, diethyldimethoxysilane, methyltriethoxysilane, ethyltrimethoxysilane, and (3,3,3-trifluoropropyl)trimethoxysilane;

arylalkoxysilanes such as diphenyldimethoxysilane and phenyltriethoxysilane; disiloxanes such as hexamethyldisiloxane (HMDSO); aminosilanes such as bis(dimethylamino)dimethylsilane, bis(dimethylamino)methylvinylsilane, bis(ethylamino)dimethylsilane, diethylaminotrimethylsilane, dimethylaminodimethylsilane, tetrakisdimethylaminosilane, and tris(dimethylamino)silane; silazanes such as hexamethyldisilazane, hexamethylcyclotrisilazane, heptamethyldisilazane, nonamethyltrisilazane, octamethylcyclotetrasilazane, and tetramethyldisilazane; cyanatosilanes such as tetraisocyanatosilane; halogenosilanes such as triethoxyfluorosilane; alkenylsilanes such as diallyldimethylsilane and allyltrimethylsilane; substituted or unsubstituted alkylsilanes such as di-t-butylsilane, 1,3-disilabutane, bis(trimethylsilyl)methane, trimethylsilane, tetramethylsilane, tris(trimethylsilyl)methane, tris(trimethylsilyl)silane, and benzyltrimethylsilane; silylalkynes such as bis(trimethylsilyl)acetylene, trimethylsilylacetylene, and 1-(trimethylsilyl)-1-propyne;

silylalkenes such as 1,4-bistrimethylsilyl-1,3-butadiyne and cyclopentadienyltrimethylsilane; arylalkylsilanes such as phenyldimethylsilane and phenyltrimethylsilane; alkynylalkylsilanes such as propargyltrimethylsilane; alkenylalkylsilanes such as vinyltrimethylsilane; disilanes such as hexamethyldisilane; siloxanes such as octamethylcyclotetrasiloxane, tetramethylcyclotetrasiloxane, and hexamethylcyclotetrasiloxane; N,O-bis(trimethylsilyl)acetamide; bis(tnmethylsilyl)carbodiimide; and the like.

Examples of the hydrocarbon include alkanes such as methane, ethane, propane, butane, pentane, and hexane; alkenes such as ethylene, propylene, butene, and pentene; alkadienes such as pentadiene and butadiene; alkynes such as acetylene and methylacetylene; aromatic hydrocarbons such as benzene, toluene, xylene, indene, naphthalene, and phenanthrene; cycloalkanes such as cyclopropane and cyclohexane; cycloalkenes such as cyclopentene and cyclohexene; and the like.

These compounds (ions) may be used either alone or in combination.

The dose may be appropriately determined depending on the application (usage) of the resulting formed article (e.g., gas barrier capability and transparency required for the application), and the like.

Ions may be implanted by irradiating ions (ion beams) accelerated by applying an electric field, or may be implanted by implanting ions present in plasma (plasma ion implantation method), for example. It is preferable to use the plasma ion implantation method since a formed article that exhibits an excellent gas barrier capability and the like can be conveniently obtained.

The plasma ion implantation method may be implemented by generating plasma in an atmosphere containing a plasma-generating gas, and implanting ions (cations) present in the plasma into the surface area of the ion implantation target layer by applying a negative high voltage pulse to the ion implantation target layer, for example.

The thickness of an area in which the ion-implanted layer is formed may be controlled adjusting the implantation conditions (e.g., type of ion, applied voltage, and implantation time), and may be determined depending on the thickness of the ion implantation target layer, the application (usage) of the formed article, and the like. The thickness of an area in which the ion-implanted layer is formed is normally 10 to 1000 nm.

Whether or not ions have been implanted may be determined by performing elemental analysis on the surface area having a depth up to about 10 nm using X-ray photoelectron spectroscopy (XPS).

The shape of the formed article according to one embodiment of the invention is not particularly limited. For example, the formed article may be in the shape of a film, a sheet, a rectangular parallelepiped, a polygonal purism, a tube, or the like. When using the formed article as an electronic device member (described later), the formed article is preferably in the shape of a film or a sheet. The thickness of the film may be appropriately determined depending on the application of the electronic device.

The formed article (1) according to one embodiment of the invention may include only the gas barrier layer, or may further include an additional layer. The additional layer may be a single layer, or may include a plurality of identical or different layers.

The formed article (2) may include only the ion-implanted layer, or may further include an additional layer.

The additional layer may be a single layer, or may include a plurality of identical or different layers.

When the formed article according to one embodiment of the invention is a laminate, the thickness of the laminate is not particularly limited, and may be appropriately determined depending on the application of the target electronic device.

When the formed article according to one embodiment of the invention is a laminate that includes the gas barrier layer (ion-implanted layer) and the additional layer, these layers may be stacked in an arbitrary order.

The gas barrier layer (ion-implanted layer) may be situated at an arbitrary position, but is preferably formed in the surface area of the formed article from the viewpoint of production efficiency and the like. The gas barrier layer (ion-implanted layer) may be formed on one side or each side of the additional layer.

Examples of the additional layer include a base layer, an inorganic compound layer, an impact-absorbing layer, a conductor layer, a primer layer, and the like.

Base layer

A material for forming the base layer is not particularly limited as long as the object of the formed article is not impaired. Examples of the material for forming the base layer include polyimides, polyamides, polyamideimides, polyphenylene ethers, polyether ketones, polyether ether ketones, polyolefins, polyesters, polycarbonates, polysulfones, polyether sulfones, polyphenylene sulfides, polyallylates, acrylic resins, cycloolefin polymers, aromatic polymers, and the like.

Among these, polyesters, polyamides, or cycloolefin polymers are preferable due to excellent transparency and versatility. It is more preferable to use polyesters or cycloolefin polymers.

Examples of the polyesters include polyethylene terephthalate, polybuthylene terephthalate, polyethylene naphthalate, polyarylate, and the like.

Examples of the polyamides include wholly aromatic polyamides, nylon 6, nylon 66, nylon copolymers, and the like.

Examples of the cycloolefin polymers include norbornene polymers, monocyclic olefin polymers, cyclic conjugated diene polymers, vinyl alicyclic hydrocarbon polymers, and hydrogenated products thereof. Specific examples of the cycloolefin polymers include APEL (ethylene-cycloolefin copolymer manufactured by Mitsui Chemicals Inc.), ARTON (norbornene polymer manufactured by JSR Corporation), ZEONOR (norbornene polymer manufactured by Zeon Corporation), and the like.

Inorganic compound layer

The inorganic compound layer is formed of one or more inorganic compounds. Examples of the inorganic compound that forms the inorganic compound layer include inorganic compounds that can be deposited under vacuum, and exhibit a gas barrier capability, such as inorganic oxides, inorganic nitrides, inorganic carbides, inorganic sulfides, and composites thereof (e.g., inorganic oxynitride, inorganic oxycarbide, inorganic carbonitride, and inorganic oxycarbonitride). Among these, it is preferable to use an inorganic oxide, an inorganic nitride, or an inorganic oxynitride.

Examples of the inorganic oxide include metal oxides shown by $MO_x$.

Note that M represents a metal element. The range of x differs depending on M. For example, x=0.1 to 2.0 when M is silicon (Si), x=0.1 to 1.5 when M is aluminum (Al), x=0.1 to 1.0 when M is magnesium (Mg), x=0.1 to 1.0 when M is calcium (Ca), x=0.1 to 0.5 when M is potassium (K), x=0.1 to 2.0 when M is tin (Sn), x=0.1 to 0.5 when M is sodium (Na), x=0.1 to 1.5 when M is boron (B), x=0.1 to 2.0 when M is titanium (Ti), x=0.1 to 1.0 when M is lead (Pb), x=0.1 to 2.0 when M is zirconium (Zr), and x=0.1 to 1.5 when M is yttrium (Y).

It is preferable to use silicon oxide (M=silicon), aluminum oxide (M=aluminum), or titanium oxide (M=titanium) due to excellent transparency and the like. It is more preferable to use silicon oxide. It is preferable that x=1.0 to 2.0 when M is silicon, x=0.5 to 1.5 when M is aluminum, and x=1.3 to 2.0 when M is titanium.

Examples of the inorganic nitride include metal nitrides shown by $MN_y$.

Note that M represents a metal element. The range of y differs depending on M. For example, y=0.1 to 1.3 when M is silicon (Si), y=0.1 to 1.1 when M is aluminum (Al), y=0.1 to 1.3 when M is titanium (Ti), and y=0.1 to 1.3 when M is tin (Sn).

It is preferable to use silicon nitride (M=silicon), aluminum nitride (M=aluminum), titanium nitride (M=titanium), or tin nitride (M=tin) due to excellent transparency and the like. It is more preferable to use silicon nitride (SiN). It is preferable that y=0.5 to 1.3 when M is silicon, y=0.3 to 1.0 when M is aluminum, y=0.5 to 1.3 when M is titanium, and y=0.5 to 1.3 when M is tin.

Examples of the inorganic oxynitride include metal oxynitrides shown by $MO_xN_y$.

Note that M represents a metal element. The ranges of x and y differ depending on M. For example, x=1.0 to 2.0 and y=0.1 to 1.3 when M is silicon (Si), x=0.5 to 1.0 and y=0.1 to 1.0 when M is aluminum (Al), x=0.1 to 1.0 and y=0.1 to 0.6 when M is magnesium (Mg), x=0,1 to 1.0 and y=0.1 to 0.5 when M is calcium (Ca), x=0.1 to 0.5 and y=0.1 to 0.2 when M is potassium (K), x=0.1 to 2.0 and y=0.1 to 1.3 when M is tin (Sn), x=0.1 to 0.5 and y=0.1 to 0.2 when M is sodium (Na), x=0.1 to 1,0 and y=0,1 to 0.5 when M is boron (B), x=0.1 to 2.0 and y=0.1 to 1.3 when M is titanium (Ti), x=0.1 to 1.0 and y=0.1 to 0.5 when M is lead (Pb), x=0.1 to 2.0 and y=0.1 to 1.0 when M is zirconium (Zr), and x=0.1 to 1.5 and y=0.1 to 1.0 when M is yttrium (Y).

It is preferable to use silicon oxynitride (M=silicon), aluminum oxynitride (M=aluminum), or titanium oxynitride (M=titanium) due to excellent transparency and the like. It is more preferable to use silicon oxynitride. It is preferable that x=1.0 to 2.0 and y=0.1 to 1.3 when M is silicon, x=0.5 to 1.0 and y=0.1 to 1.0 when M is aluminum, and x=1.0 to 2.0 and y=0.1 to 1.3 when M is titanium.

Note that the metal oxide, the metal nitride, and the metal oxynitride may include two or more types of metals.

The inorganic compound layer may be formed by an arbitrary method. For example, the inorganic compound layer may be formed by deposition, sputtering, ion plating, thermal CVD, plasma CVD, dynamic ion fixing, or the like. Among these, it is preferable to use magnetron sputtering since a laminate that exhibits an excellent gas barrier capability, can be conveniently obtained.

The thickness of the inorganic compound layer is not particularly limited, but is preferably 10 to 1000 nm, more preferably 20 to 500 nm, and particularly preferably 50 to 200 nm, from the viewpoint of obtaining a gas barrier capability.

Impact-absorbing layer

The impact-absorbing layer prevents a situation in which cracks occur in the inorganic compound layer when an impact is applied to the inorganic compound layer. A material for forming the impact-absorbing layer is not particularly limited. Examples of the material for forming the impact-absorbing layer include acrylic resins, urethane resins, silicone resins, olefin resins, rubber materials, and the like. Among these, acrylic resins, silicone resins, and rubber materials are preferable.

Examples of the acrylic resins include acrylic resins that include at least one polymer selected from a (meth) acrylate homopolymer, a copolymer that includes two or more (meth)acrylate units, and a copolymer of a (meth)acrylate and another functional monomer, as the main component. Note that the term "(meth)acrylic acid" used herein refers to acrylic acid or methacrylic acid (hereinafter the same).

It is preferable to use a (meth)acrylate in which the ester moiety has 1 to 20 carbon atoms, and more preferably a (meth) acrylate in which the ester moiety has 4 to 10 carbon atoms, since the storage modulus of the impact-absorbing layer can be easily adjusted within a given range. Examples of such a (meth)acrylate include butyl (meth)acrylate, pentyl (meth)acrylate, hexyl (meth)acrylate, heptyl (meth)acrylate, octyl (meth)acrylate, 2-ethylhexyl (meth)acrylate, nonyl (meth)acrylate, decyl (meth)acrylate, and the like.

Examples of the silicone resins include silicone resins that include a dimethylsiloxane as the main component. Examples of the rubber material include rubber materials that include isoprene rubber, styrene-butadiene rubber, polyisobutylene rubber, styrene-butadiene-styrene rubber, or the like as the main component.

The impact-absorbing layer may include additives such as an antioxidant, a tackifier, a plasticizer, a UV absorber, a coloring agent, and an antistatic agent.

A product commercially available as a pressure-sensitive adhesive, a coating material, a sealing material, or the like may also be used as the material for forming the impact-absorbing layer. It is preferable to use a pressure-sensitive adhesive (e.g., acrylic pressure-sensitive adhesive, silicone pressure-sensitive adhesive, or rubber pressure-sensitive adhesive).

The impact-absorbing layer may be formed by an arbitrary method. For example, the impact-absorbing layer may be formed by applying a solution that includes the material (e.g., pressure-sensitive adhesive) for forming the impact-absorbing layer and an optional component (e.g., solvent) to the layer on which the impact-absorbing layer is to be formed, drying the resulting film, and optionally heating the dried film in the same manner as in the case of forming the polyorganosiloxane compound-containing layer.

Alternatively, the impact-absorbing layer may be formed on a release base, and transferred to a layer on which the impact-absorbing layer is to be formed.

The thickness of the impact-absorbing layer is normally 1 to 100 $\mu$m, and preferably 5 to 50 $\mu$m.

Conductor layer

Examples of a material for forming the conductor layer include metals, alloys, metal oxides, electrically conductive compounds, mixtures thereof, and the like. Specific examples of the material for forming the conductor layer include conductive metal oxides such as antimony-doped tin oxide (ATO), fluorine-doped tin oxide (FTO), tin oxide, zinc oxide, indium oxide, indium tin oxide (ITO), and indium zinc oxide (IZO); metals such as gold, silver, chromium, and nickel; a mixture of a metal and a conductive metal oxide; inorganic conductive substances such as copper iodide and copper sulfide; organic conductive materials such as polyaniline, polythiophene, and polypyrrole; and the like. The conductor layer may be a laminate that includes a plurality of layers formed or these materials.
It is preferable to use a conductive metal oxide (particularly preferably ITO) as the material for forming the conductor layer from the viewpoint of transparency.
The conductor layer may be formed by deposition, sputtering, ion plating, thermal CVD, plasma CVD, or the like. It is preferable to form the conductor layer by sputtering since the conductor layer can be conveniently formed.
When forming the conductor layer by sputtering, a discharge gas (e.g., argon) is introduced into a vacuum chamber. A high-frequency voltage or a direct-current voltage is applied between a target and a substrate to generate plasma. The plasma collides with the target, so that the target material is splashed on the substrate, and adheres to the substrate to obtain a thin film. The target is formed of the material for forming the conductor layer.
The thickness of the conductor layer may be appropriately selected depending on the application and the like. The thickness of the conductor layer is normally 10 nm to 50 $\mu$m, and preferably 20 nm to 20 $\mu$m.
The surface resistivity of the conductor layer is normally 1000 $\Omega$/sq or less.
The conductor layer may optionally be patterned. The conductor layer may be patterned by chemical etching (e.g., photolithography), physical etching using a laser or the like, vacuum deposition using a mask, sputtering, a lift-off method, printing, or the like.

Primer layer

The primer layer improves the interlayer adhesion between the base layer and the ion-implanted layer. A gas barrier film that exhibits excellent interlayer adhesion and surface flatness (smoothness) can be obtained by providing the primer layer.
An arbitrary known material may be used to form the primer layer. Examples of the material that may be used to form the primer layer include silicon-containing compounds; a photopolymerizable composition that includes a photopolymerizable compound formed of a photopolymerizable monomer and/or a photopolymerizable prepolymer, and an initiator that generates radicals at least due to visible light; resins such as a polyester resin, a polyurethane resin (particularly a two-component curable resin that includes an isocyanate compound and a polyacryl polyol, a polyester polyol, a polyether polyol, or the like), an acrylic resin, a polycarbonate resin, a vinyl chloride/vinyl acetate copolymer, a polyvinyl butyral resin, and a nitrocellulose resin; alkyl titanates; ethyleneimine; and the like. These materials may be used either alone or in combination.
The primer layer may be formed by dissolving or dispersing the material for forming the primer layer in an appropriate solvent to prepare a primer layer-forming solution, applying the primer layer-forming solution to one side or each side of the base layer, drying the resulting film, and optionally heating the dried film.
The primer layer-forming solution may be applied to the base layer by a wet coating method. Examples of the wet coating method include dipping, roll coating, gravure coating, knife coating, air knife coating, roll knife coating, die coating, screen printing, spray coating, a gravure offset method, and the like.
The film formed by applying the primer layer-forming solution may be dried by hot-air drying, heat roll drying, infrared irradiation, or the like. The thickness of the primer layer is normally 10 to 1000 nm.
Ions may be implanted into the primer layer in the same manner as in the case of forming the ion-implanted layer (described later). A gas barrier film that exhibits a more excellent gas barrier capability can be obtained by implanting ions into the primer layer.
The formed article according to one embodiment of the invention exhibits an excellent gas barrier capability and excellent transparency. When the formed article according to one embodiment of the invention has a film-like or sheet-like shape (hereinafter referred to as "film-like shape"), it is preferable that the formed article exhibit excellent bending resistance, and maintain its gas barrier capability even it the formed article is bent.
The formed article according to one embodiment of the invention exhibits an excellent gas barrier capability since the formed article has a low gas (e.g., water vapor) transmission rate. For example, the water vapor transmission rate of the formed article at a temperature of 40°C and a relative humidity of 90% is normally 5.3 g/m$^2$/day or less, preferably 1.5 g/m$^2$/day or less, and more preferably 1.0 g/m$^2$/day or less. The gas (e.g., water vapor) transmission rate of the formed article may be measured using a known gas transmission rate measurement apparatus.

Whether or not the formed article according to one embodiment of the invention exhibits excellent transparency may be confirmed by measuring the light transmittance of the formed article. The formed article has a visible light transmittance (total light transmittance) at a wavelength of 550 nm of 90% or more. The visible light transmittance of the formed article may be measured using a known visible light transmittance measurement apparatus.

Whether or not the formed article exhibits excellent bending resistance, and maintains its gas barrier capability even when the formed article is bent may be confirmed by bending the film-like formed article, applying a pressure to the formed article, determining whether or not the bent area has deteriorated after unbending the formed article, and determining whether or not the water vapor transmission rate has decreased to a large extent. The film-like formed article according to one embodiment of the invention advantageously maintains its gas barrier capability as compared with an inorganic film having an identical thickness even when the formed article is bent.

For example, when the formed article according to one embodiment of the invention is bent at the center so that the gas barrier layer (ion-implanted layer) is positioned on the outer side, and is passed between two rolls of a laminator at a given laminating speed and a given temperature (bending test), and the bent area is observed using a microscope, cracks are not observed.

The formed article according to one embodiment of the invention has a change rate of water vapor transmission (%) (see the following expression (1)) due to the bending test of less than 12%.

[Expression 1]

change rate of water vapor transmission (%) = {[(water vapor transmission rate after bending test) - (water vapor transmission rate before bending test)] / (water vapor transmission rate before bending test)} × 100

2) Method for producing formed article

A method for producing a formed article according to one embodiment of the invention includes implanting ions into a silicate layer of a formed body that includes the silicate layer in a surface area.

The formed article (1) as well as the formed article (2) according to the embodiments of the invention can be conveniently and efficiently produced by this method.

In the method for producing a formed article according to one embodiment of the invention, it is preferable to implant ions into a silicate layer of a long formed body that includes the silicate layer in a surface area while feeding the long formed body in a given direction to produce a formed article.

According to this method, ions can be implanted into a long formed body wound around a feed-out roll while feeding the formed body in a given direction, which can then be wound around a wind-up roll, for example. Therefore, an ion-implanted formed article can be continuously produced.

The long formed body is in the shape of a film. The formed body may include only the silicate layer, or may be a laminate that includes the silicate layer in a surface area, and further includes an additional layer.

The thickness of the formed body is preferably 1 to 500 μm, and more preferably 5 to 300 μm, from the viewpoint of winding/unwinding operability and feeding operability.

Ions may be implanted into the silicate layer by an arbitrary method. It is preferable to form an ion-implanted layer in the surface area of the silicate layer using the plasma ion implantation method.

The plasma ion implantation method includes applying a negative high voltage pulse to the formed body that includes the silicate layer in the surface area and is exposed to plasma to implant ions present in the plasma into the surface area of the silicate layer.

It is preferable to use (A) a plasma ion implantation method that implants ions present in plasma generated by utilizing an external electric field into the surface area of the silicate layer, or (B) a plasma ion implantation method that implants ions present in plasma generated due to an electric field produced by applying a negative high pulsed voltage to the silicate layer into the surface area of the silicate layer.

When using the method (A), it is preferable to set the ion implantation pressure (plasma ion implantation pressure) to 0.01 two 1 Pa. When the ion implantation pressure is within the above range, a uniform ion-implanted layer that exhibits an excellent gas barrier capability and the like can be conveniently and efficiently formed.

The method (B) does not require increasing the degree of decompression, allows a simple operation, and significantly reduces the processing time. Moreover, the entire silicate layer can be uniformly processed, and ions present in the plasma can be continuously implanted into the surface area of the silicate layer with high energy when applying a negative high voltage pulse. The method (B) also has an advantage in that a high-quality ion-implanted layer can be uniformly formed in the surface area of the silicate layer by merely applying a negative high voltage pulse to the silicate layer without requiring a special means such as a high-frequency electric power supply (e.g., radio frequency (RF) power supply or microwave power supply).

When using the method (A) or (B), the pulse width when applying a negative high voltage pulse (i.e., during ion implantation) is preferably 1 to 15 $\mu$s. When the pulse width is within the above range, a transparent and uniform ion-implanted layer can be formed more conveniently and efficiently.

The voltage applied when generating plasma is preferably -1 to -50 kV, more preferably -1 to -30 kV, and particularly preferably -5 to -20 kV. If the applied voltage is higher than -1 kV, the dose may be insufficient, so that the desired performance may not be obtained. If the applied voltage is lower than -50 kV, the formed article may be charged during ion implantation, or the formed article may be colored, for example.

Examples of a raw material gas that produces plasma ions include those mentioned above in connection with the formed article.

A plasma ion implantation apparatus is used when implanting ions present in plasma into the surface area of the layer.

Specific examples of the plasma ion implantation apparatus include ($\alpha$) a apparatus that causes the ion implantation target layer to be evenly enclosed by plasma by superimposing high-frequency electric power on a feed-through that applies a negative high voltage pulse to the ion implantation target layer so that ions present in the plasma are attracted to and collide with the target, and thereby implanted and deposited therein (JP-A-2001-26887), ($\beta$) a apparatus that includes an antenna in a chamber, wherein high-frequency electric power is applied to generate plasma, and positive and negative pulses are alternately applied to the ion implantation target layer after the plasma has reached an area around the ion implantation target layer, so that ions present in the plasma are attracted to and Implanted into the target while heating the ion implantation target layer, causing electrons present in the plasma to be attracted to and collide with the target due two the positive pulse, and applying the negative pulse while controlling the temperature by controlling the pulse factor (JP-A-2001-156013), (y) a plasma ion implantation apparatus that generates plasma using an external electric field utilizing a high-frequency electric power supply such as a microwave power supply, and causes ions present in the plasma to be attracted to and implanted into the target by applying a high voltage pulse, ($\delta$) a plasma ion implantation apparatus that implants ions present in plasma generated due to an electric field produced by applying a high voltage pulse without using an external electric field, and the like.

It is preferable to use the plasma ion implantation apparatus ($\gamma$) or ($\delta$) since the plasma ion implantation apparatus ($\gamma$) or ($\delta$) allows a simple operation, significantly reduces the processing time, and can be continuously used. A method that utilizes the plasma ion implantation apparatus ($\gamma$) or ($\delta$) is described in detail below with reference to the drawings.

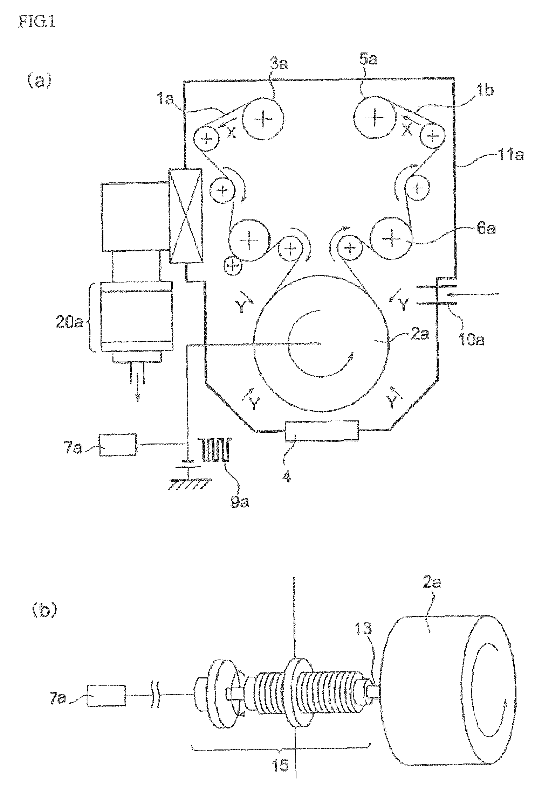

FIG. 1 is a view schematically illustrating a continuous plasma ion implantation apparatus that includes the plasma ion implantation apparatus ($\gamma$).

In FIG. 1(a), reference sign 1a indicates a long film-like formed body (hereinafter referred to as "film") that includes a hydrolysis/dehydration-condensation product of a tetrafunctional organosilane compound in the surface area, reference sign 11a indicates a chamber, reference sign 20a indicates a turbo-molecular pump, reference sign 3a indicates a feed-out roll around which the film 1a is wound before ion implantation, reference sign 5a indicates a wind-up roll around which an ion-implanted film (formed article) 1a is wound, reference sign 2a indicates a high-voltage applying rotary can, reference sign 6a indicates a driving roll, reference sign 10a indicates a gas inlet, reference sign 7a indicates a high voltage pulsed power supply, and reference sign 4 indicates a plasma discharge electrode (external electric field). FIG. 1(b) is a perspective view illustrating the high-voltage applying rotary can 2a, wherein reference sign 15 indicates a high-voltage application terminal (feed-through).

The long film 1a that includes the ion implantation target layer in the surface area is a film which the silicate layer is formed on a base layer.

In the continuous plasma ion implantation apparatus illustrated in FIG. 1, the film 1a is fed from the feed-out roll 3a in the direction of an arrow X inside the chamber 11a, passes through the high-voltage applying rotary can 2a, and is wound around the wind-up roll 5a. The film 1a may be wound and fed (carried) by an arbitrary method. In one embodiment of the invention, the film 1a is fed (carried) by rotating the high-voltage applying rotary can 2a at a constant speed. The high-voltage applying rotary can 2a is rotated by rotating a center shaft 13 of the high-voltage application terminal 15 using a motor.

The high-voltage application terminal 15, the driving rolls 6a that come in contact with the film 1a, and the like are formed of an insulator. For example, the high-voltage application terminal 15, the driving rolls 6a, and the like are formed by coating the surface of alumina with a resin (e.g., polytetrafluoroethylene). The high-voltage applying rotary can 2a is formed of a conductor (e.g., stainless steel).

The feeding speed of the film 1a may be appropriately set. The transfer speed of the film 1a is not particularly limited as long as ions are implanted into the surface area (silicate layer) of the film 1a so that the desired ion-implanted layer is formed when the film 1a is fed from the feed roll 3a and wound around the wind-up roll 5a. The film winding speed (feeding speed) is determined depending on the applied voltage, the size of the apparatus, and the like, but is normally 0.1 to 3 m/min, and preferably 0.2 to 2.5 m/min.

The pressure inside the chamber 11a is reduced by discharging air from the chamber 11a using the turbo-molecular pump 20a connected to a rotary pump. The degree of decompression is normally $1\times10^{-4}$ to 1 Pa, and preferably $1\times10^{-3}$ to $1\times1^{-2}$ Pa.

An ion implantation gas is introduced into the chamber 11a through the gas inlet 10a so that the chamber 11a is filled with the ion implantation gas under reduced pressure. Note that the ion implantation gas also serves as a plasma-generating gas.

Plasma is then generated using the plasma discharge electrode 4 (external electric field). The plasma may be generated by a known method using a high-frequency electric power supply (e.g., microwave power supply or RF power supply).

A negative high voltage pulse 9a is applied from the high voltage pulsed power supply 7a connected to the high-voltage applying rotary can 2a through the high-voltage application terminal 15. When a negative high voltage pulse is applied to the high-voltage applying rotary can 2a, ions present in the plasma are attracted to and implanted into the surface of the film around the high-voltage applying rotary can 2a (arrow Y in FIG. 1(a)), so that a film-like formed article 1b is obtained.

The pressure during ion implantation (i.e., the pressure of plasma gas inside the chamber 11a) is preferably 0.01 to 1 Pa. The pulse width during ion implantation is preferably 1 to 15 μs. The negative high voltage applied to the high-voltage applying rotary can 2a is preferably -1 to -50 kV.

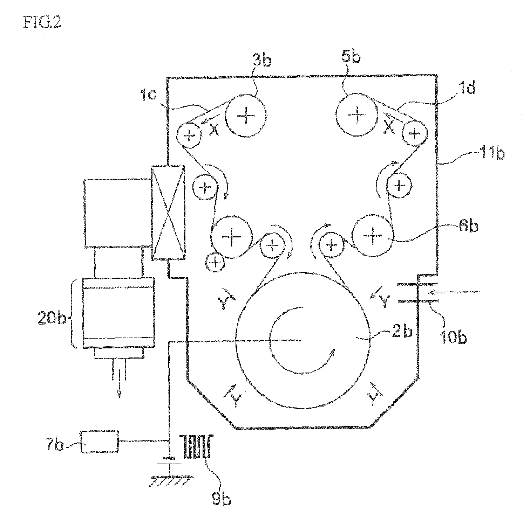

When using a continuous plasma ion implantation apparatus illustrated in FIG. 2, ions are implanted into a silicate layer of a film that includes the silicate layer in a surface area as described below.

The apparatus illustrated in FIG. 2 includes the plasma ion implantation apparatus (δ). The plasma ion implantation apparatus (δ) generates plasma by applying only an electric field due to a high voltage pulse without using an external electric field (i.e., the plasma discharge electrode 4 illustrated in FIG. 1).

In the continuous plasma ion implantation apparatus illustrated in FIG. 2, a film 1c (film-like formed body) is fed from a feed-out roll 3b in the direction of an arrow X (see FIG. 2) by rotating a high-voltage applying rotary can 2b, and wound around a wind-up roll 5b.

The continuous plasma ion implantation apparatus illustrated in FIG. 2 implants ions into the surface area of the silicate layer of the film as described below.

The film 1c is placed in a chamber 11b in the same manner as the plasma ion implantation apparatus illustrated in FIG. 1. The pressure inside the chamber 11b is reduced by discharging air from the chamber 11b using a turbo-molecular pump 20b connected to a rotary pump. An ion implantation gas is introduced into the chamber 11b through a gas inlet 10b so that the chamber 11b is filled with the ion implantation gas under reduced pressure.

The pressure during ion implantation (i.e., the pressure of plasma gas inside the chamber 11b) is 10 Pa or less, preferably 0.01 to 5 Pa, and more preferably 0.01 to 1 Pa.

A high voltage pulse 9b is applied from a high voltage pulsed power supply 7b connected to the high-voltage applying rotary can 2b through a high-voltage application terminal (not shown) while feeding the film 1c in the direction X illustrated in FIG. 2.

When a negative high voltage pulse is applied to the high-voltage applying rotary can 2b, plasma is generated along the film 1c positioned around the high-voltage applying rotary can 2b, and ions present in the plasma are attracted to and implanted into the surface of the film 1c around the high-voltage applying rotary can 2b (arrow Y in FIG. 2). When ions are implanted into the surface area of the silicate layer of the film 1c, an ion-implanted layer is formed in the surface of the film, A film-like formed article 1d is thus obtained.

The applied voltage and the pulse width employed when applying a negative high voltage pulse to the high-voltage applying rotary can 2b, and the pressure employed during ion implantation are the same as those employed when using the continuous plasma ion implantation apparatus illustrated in FIG. 1.

Since the plasma ion implantation apparatus illustrated in FIG. 2 is configured so that the high voltage pulsed power supply also serves as a plasma generation means, a special means such as a high-frequency electric power supply (e.g., RF power supply or microwave power supply) is unnecessary. An ion-implanted layer can be continuously formed by implanting ions present in the plasma into the surface area of the silicate layer by merely applying a negative high voltage pulse. Therefore, a formed article in which an ion-implanted layer is formed in the surface area or a film can be mass-produced.

3) Electronic device member and electronic device

An electronic device member according to one embodiment of the invention includes the formed article according to one embodiment of the invention. Therefore, since the electronic device member according to one embodiment of the invention exhibits an excellent gas barrier capability, a deterioration in the element (member) due to gas (e.g., water vapor) can be prevented. Since the electronic device member exhibits high light transmittance, the electronic device member may suitably be used as a display member for liquid crystal displays or electroluminescence displays; a solar cell back side protective sheet; and the like.

An electronic device according to one embodiment of the invention includes the electronic device member according to one embodiment of the invention. Specific examples of the electronic device include a liquid crystal display, an organic EL display, an inorganic EL display, electronic paper, a solar cell, and the like.

Since the electronic device according to one embodiment of the invention includes the electronic device member that includes the formed article according to one embodiment of the invention, the electronic device exhibits an excellent gas barrier capability and excellent transparency.

EXAMPLES

The invention is further described below by way of examples. Note that the invention is not limited to the following examples.

The following plasma ion implantation apparatus, water vapor transmission rate measurement apparatus, water vapor transmission rate measurement conditions, total light transmittance measurement apparatus, surface resistivity measurement apparatus, bending test method, and gas barrier layer (ion-implanted layer) surface layer XPS elemental analysis apparatus were used in the examples.

Plasma ion implantation apparatus

    RF power supply: "RF56000" manufactured by JEOL Ltd.
    High voltage pulsed power supply: "PV-3-HSHV-0835" manufactured by Kurita Seisakusho Co., Ltd.

Note that a apparatus that implants ions using an external electric field was used as the plasma ion implantation apparatus.

Measurement of water vapor transmission rate

The water vapor transmission rate was measured using a water vapor transmission rate measurement apparatus ("PERMATRAN" manufactured by MOCON).
The water vapor transmission rate was measured at a temperature of 40°C and a relative humidity or 90%.

Measurement of total light transmittance

The total light transmittance at a wavelength of 550 nm was measured using a haze meter ("NDH2000" manufactured by Nippon Denshoku Industries, Co., Ltd.).

Bending test

The formed article was bent at the center so that the ion-implanted layer (side) (the side of the silicate layer in Comparative Examples 2 and 3, and the side of the $SiO_2$ film in Comparative Example 4) was positioned on the outer side. The formed article was passed between two rolls of a laminator ("LAMIPACKER LPC1502" manufactured by Fujipla, Inc.) at a laminating speed of 5 m/min and a temperature of 23°C. The bent area was observed using a microscope (magnification: 100) to determine the presence or absence of cracks. A case where cracks were not observed is indicated by "No", and a case where cracks were observed it indicated by "Yes".

XPS elemental analysis

X-ray photoelectron spectroscopy (XPS) elemental analysis was performed under the following conditions using an XPS measurement apparatus.

Measurement apparatus: "PHI Quantera SXM" manufactured by ULVAC-PHI, Incorporated
X-ray source: AlKα
X-ray beam diameter: 100 μm
Power: 25 W
Voltage: 15 kV
Take-off angle: 45°
Degree of vacuum: $5.0 \times 10^{-8}$ Pa

Example 1

A silicate coating liquid ("Colcoat N103-X" manufactured by Colcoat Co., Ltd., weight average molecular weight of silicate: 1000 to 100,000) (hydrolysis/dehydration-condensation compound of tetraethoxysilane) was applied to a polyethylene terephthalate film ("PET50 A-4100" manufactured by Toyobo Co., Ltd., thickness: 50 μm (hereinafter referred to as "PET film")) (base layer), and dried to form a resin layer (thickness: 75 nm) to obtain a formed body. Argon (Ar) was plasma-ion-implanted into the surface of the resin layer of the formed body under the following conditions using the plasma ion implantation apparatus illustrated in FIG. 1 to obtain a formed article 1.

Plasma ion implantation conditions

Plasma-generating gas: argon
Gas flow rate: 100 sccm
Duty ratio: 1.0%
Repetition frequency 1000 Hz
Applied voltage: -15 kV
RF power supply: frequency: 13.56 MHz, applied electric power: 1000 W
Chamber internal pressure: 0.2 Pa
Pulse width: 5 μs
Professing time (ion implantation time): 5 min
Feeding speed: 0.2 m/min

Example 2

A formed article 2 was obtained in the same manner as in Example 1, except that helium was used as the plasma-generating gas.

Example 3

A formed article 3 was obtained in the same manner as in Example 1, except that krypton was used as the plasma-generating gas.

Example 4

A formed article 4 was obtained in the same manner as in Example 1, except that nitrogen was used as the plasma-generating gas.

Example 5

A formed article 5 was obtained in the same manner as in Examples 1, except that oxygen was used as the plasma-generating gas.

Example 6

A formed article 6 was obtained in the same manner as in Example 1, except that the applied voltage was changed to -10 kV.

Example 7

A formed article 7 was obtained in the same manner as in Example 1, except that the applied voltage was changed to -20 kV.

Example 8

A formed article 8 was obtained in the same manner as in Example 1, except that a silicate coating liquid ("Colcoat PX" manufactured by Colcoat Co., Ltd., weight average molecular weight of silicate: 20,000 to 30,000) (hydrolysis/dehydration-condensation of tetraethoxysilane) was used as the coating liquid for forming the resin layer.

Comparative Example 1

A PET film ("PET50 A-4100" manufactured by Toyobo Co., Ltd., thickness: 50 $\mu$m) was used directly as a formed article 9.

Comparative Example 2

A formed article 10 was obtained in the same manner as in Example 1, except that plasma ion implantation was not performed.

Comparative Example 3

A formed article 11 was obtained in the same manner as in Example 8, except that plasma ion implantation was not performed.

Comparative Example 4

An $SiO_2$ layer (thickness) was formed on a PET film ("PET50 A-4100" manufactured by Toyobo Co., Ltd., thickness: 50 $\mu$m) by sputtering (apparatus) to obtain a formed article 12.

Comparative Example 5

A formed body was obtained in the same manner as in Example 1, except that a polyorganosiloxane compound silicone release agent ("KS835" manufactured by Shin-Etsu Chemical Co., Ltd. (silicone resin containing polydimethylsiloxane as the main component)) was used as the coating liquid for forming the resin layer. A formed article 13 was obtained by being plasma-ion-implanted in the same manner as in Example 6, except that the resulting formed body was used.

Comparative Examples 6

A formed body was obtained in the same manner as in Example 1, except that a polyorganosiloxane compound obtained by mixing 3.97 g (20 mmol) of phenyltrimethoxysilane (manufactured by Tokyo Kasei Kogyo Co., Ltd.), 4.73 g (20 mmol) of 3-glycidoxypropyltrimethoxysilane (manufactured by Tokyo Kasei Kogyo Co., Ltd.), 20 ml of toluene, 10 ml of distilled water, and 0.10 g (1 mol) of phosphoric acid (manufactured by Kanto Chemical Co., Ltd.), and reacting the components at room temperature for 24 hours, was used as the coating liquid for forming the resin layer. A formed article 14 was obtained by being plasma-ion-implanted in the same manner as in Example 6, except that the resulting formed body was used.

The gas barrier layer-forming material, the ion implantation gas, and the applied voltage used in Examples 1 to 8 and Comparative Examples 1 to 6 are shown in Table 1. The meaning of symbols A to E in Table 1. is shown below.

A: Polysiloxane layer formed using silicate coating liquid ("Colcoat N103-X" manufactured by Colcoat Co., Ltd., weight average molecular weight of silicate: 1000 to 100,000)
B: Polysiloxane layer formed using silicate coating liquid ("Colcoat PX" manufactured by Colcoat Co., Ltd., weight average molecular weight of silicate: 20,000 to 30,000)
C: $SiO_2$ film formed by sputtering
D: Polysiloxane layer formed using polyorganosiloxane compound silicone release agent ("KS835" manufactured by Shin-Etsu Chemical Co., Ltd. (silicone resin containing polydimethylsiloxane as the main component))
E: Polysiloxane layer formed using polyorganosiloxane compound obtained by reacting phenyltrimethoxysilane (manufactured by Tokyo Kasei Kogyo Co., Ltd.) and 3-glycidoxypropyltrimethoxysilane (manufactured by Tokyo Kasei Kogyo Cho., Ltd.)

In Examples 1 to 8 and Comparative Examples 5 and 6, implantation of ions was confirmed by subjecting the surface area (depth: up to about 10 nm or less) of the formed article to elemental analysis using an X-ray photoelectron spectrometer (manufactured by ULVAC-PHI, Incorporated). Table 1 shows the measurement results for the oxygen atom content (content rate), the carbon atom content, and the silicon atom content in the surface layer part of the ion-implanted layer (gas barrier layer) of the formed articles obtained in Examples 1 to 8 and Comparative Examples 2 to 6.
TABLE 1

| | Formed article | Gas barrier layer-forming process | | | Elemental analysis of surface layer part of gas barrier layer | | |
|---|---|---|---|---|---|---|---|
| | | Material | Implanted gas | Applied voltage (-kV) | Carbon (%) | Oxygen (%) | Silicon (%) |
| Example 1 | 1 | A | Ar | 15 | 16.35 | 60.80 | 22.85 |
| Example 2 | 2 | A | He | 15 | 17.65 | 59.64 | 22.71 |
| Example 3 | 3 | A | Kr | 15 | 21.58 | 56.78 | 21.64 |
| Example 4 | 4 | A | $N_2$ | 15 | 27.69 | 50.82 | 21.49 |
| Example 5 | 5 | A | $O_2$ | 15 | 17.42 | 59.78 | 22.80 |
| Example 6 | 6 | A | Ar | 10 | 12.39 | 63.26 | 24.35 |
| Example 7 | 7 | A | Ar | 20 | 20.10 | 60.26 | 19.64 |
| Example 8 | 8 | B | Ar | 15 | 13.64 | 61.31 | 25.05 |
| Comparative Example 1 | 9 | - | - | - | - | - | - |
| Comparative Example 2 | 10 | A | - | - | 11.85 | 63.38 | 24.77 |
| Comparative Example 3 | 11 | B | - | - | 15.02 | 61.20 | 23.78 |
| Comparative Example 4 | 12 | c | - | - | 1.21 | 33.11 | 65.68 |
| Comparative Example 5 | 13 | D | Ar | 10 | 20.60 | 56.40 | 23.00 |
| Comparative Example 6 | 14 | E | Ar | 10 | 35.50 | 45.50 | 19.00 |

The water vapor transmission rate and the total, light transmittance (wavelength: 550 nm) of the formed articles 1 to 14 obtained in Examples 1. to 8 and Comparative Examples 1 to 6 were measured. The measurement results are shown in Table 2.
The formed articles 1 to 14 obtained in Examples 1 to 8 and Comparative Examples 1 to 6 were subjected to the bending test to determine the presence or absence of cracks. The results are shown in Table 2.
The water vapor transmission rate of the formed articles 1 to 14 obtained in Examples 1 to 8 and Comparative Examples 1 to 6 was also measured after the bending test. The measurement results are shown in Table 2.
TABLE 2

| | Formed article | Before bending test | | After bending test | |
|---|---|---|---|---|---|
| | | Water vapor transmission rate (g/m²/day) | Total light transmittance (%) | Water vapor transmission rate (g/m²/day) | Cracks in gas barrier layer |
| Example 1 | 1 | 0.17 | 91.3 | 0.19 | No |
| Example 2 | 2 | 1.07 | 90.1 | 1.18 | No |
| Example 3 | 3 | 1.34 | 91.9 | 1.40 | No |
| Example 4 | 4 | 1.21 | 90.2 | 1.31 | No |
| Example 5 | 5 | 0.98 | 90.3 | 1.00 | No |
| Example 6 | 6 | 0.65 | 91.3 | 0.68 | No |
| Example 7 | 7 | 0.38 | 90.9 | 0.41 | No |
| Example 8 | 8 | 5.22 | 91.7 | 5.30 | No |
| Comparative Example 1 | 9 | 9.12 | 89.7 | 9.31 | - |
| Comparative Examples 2 | 10 | 9.05 | 92.3 | 9.21 | No |
| Comparative Example 3 | 11 | 9.38 | 92.4 | 9.38 | No |
| Comparative Example 4 | 12 | 0.52 | 91.5 | 1.21 | Yes |
| Comparative Example 5 | 13 | 1.13 | 86.70 | 1.80 | No |
| Comparative Example 6 | 14 | 1.20 | 86.35 | 1.20 | No |

As shown in Table 2, the formed articles 1 to 8 obtained in Examples 1 to 8 had a low water vapor transmission rate (i.e., exhibited an excellent gas barrier capability) as compared with the formed articles 9 to 11 obtained in Comparative Examples 1 to 3.

The formed articles 1 to 8 obtained in Examples 1 to 8 had a high total light transmittance (wavelength: 550 nm) (i.e., exhibited excellent transparency) as compared with the formed articles 13 any 14 obtained in Comparative Examples 5 and 6.

The formed articles 1 to 8 obtained in Examples 1 to 8 showed no cracks when subjected to the bending test, and had a small change rate of water vapor transmission (i.e., exhibited excellent bending resistance).

REFERENCE LIST

1a, 1c:       film-like formed body

1b, 1d:       film-like formed article

2a, 2b:       rotary can

3a, 3b:       feed-out roll

4:       plasma discharge electrode

5a, 5b:       wind-up roll

6a, 6b:     driving roll

7a, 7b:     pulsed power supply

9a, 9b:     high voltage pulse

10a, 10b:   gas inlet

11a, 11b:   chamber

13:         center shaft

15:         high-voltage application terminal

20a, 20b:   turbo-molecular pump

**Claims**

1. A formed article comprising at least a gas barrier layer,
   the gas barrier layer being formed of a material that includes silicon atoms, oxygen atoms, and carbon atoms, a carbon atoms content, a silicon atom content, and an oxygen atom content in a surface layer part of the gas barrier layer determined by XPS elemental analysis being 10.0 to 28.0%, 18.0 to 28.0%, and 48.0 to 66.0%, respectively, based on a total content (=100 atom%) of silicone atoms, oxygen atoms, and carbon atoms, and
   the formed article having a water vapor transmission rate at a temperature of 40°C and a relative humidity of 90% of 5.3 g/m$^2$/day or less, and a total light transmittance at a wavelength, of 550 nm of 90% or more.

2. A formed article comprising an ion-implanted layer that is obtained by implanting ions into a layer that includes a hydrolysis/dehydration-condensation product of a tetrafunctional organosilane compound.

3. The formed article according to claim 2, wherein the ions are obtained by ionizing at least one gas selected from a group consisting of hydrogen, oxygen, nitrogen, argon, helium, xenon, krypton, a silicon compound, and a hydrocarbon.

4. The formed article according to claim 2 or 3, wherein the ion-implanted layer is a layer obtained by implanting the ions into the layer that includes the hydrolysis/dehydration-condensation product of the tetrafunctional organosilane compound by a plasma ion implantation method.

5. The formed article according to clam 2 or 3, wherein the tetrafunctional. organosilane compound is a tetra($C_1$-$C_{10}$) alkoxysilane.

6. A method for producing the formed article according to claim 2 or 3, the method, comprising implanting ions into a surface area of a layer that is includes in a formed body and includes a hydrolysis/dehydration-condensation product of a tetrafunctional organosilane compound, the formed body including the layer that includes the hydrolysis/dehydration-condensation product of the tetrafunctional organosilane compound in a surface area.

7. The method according to claim 6, comprising implanting ions of at least one gas selected from a group consisting of hydrogen, nitrogen, oxygen, argon, helium, neon, xenon, krypton, a silicone compound, and a hydrocarbon into a layer that is included in a formed body and includes a hydrolysis/dehydration-condensation product of a tetrafunctional organosilane compound, the formed body including the layer that includes the hydrolysis/dehydration-condensation product of the tetrafunctional organosilane compound in a surface area.

8. The method according to claim 6, comprising implanting ions of at least one gas selected from a group consisting of hydrogen, nitrogen, oxygen, argon, helium, neon, xenon, krypton, a silicone compound, and a hydrocarbon into a layer that is included in a formed body and includes a hydrolysis/dehydration-condensation product of a tetrafunctional organosilane compounds by a plasma ion implantation method, the formed body including the layer that includes the hydrolysis/dehydration-condcnsation product of the tetrafunctional organosilane compound in a surface area,

9. The method according to claim 6, comprising implanting ions into a layer that is included in a long formed body and includes a hydrolysis/dehydration-condensation product of a tetrafunctional organosilane compound while feeding the long formed article in a given direction, the long formed body including the layer that includes the hydrolysis/dehydration-condensation product of the tetrafunctional organosilane compound in a surface area,

10. An electronic devices member comprising the formed article according to any one of claims 1 to 3.

11. An electronic device comprising the electronic device member according to claim 10.

FIG.1

(a)

(b)

FIG.2

EP 2 554 368 A1

## INTERNATIONAL SEARCH REPORT

International application No.

PCT/JP2011/057608

A. CLASSIFICATION OF SUBJECT MATTER
*B32B9/00*(2006.01)i, *C23C14/48*(2006.01)i, *H01L31/042*(2006.01)i

According to International Patent Classification (IPC) or to both national classification and IPC

B. FIELDS SEARCHED

Minimum documentation searched (classification system followed by classification symbols)
B32B1/00-43/00, C23C14/00-14/58, H01L31/00-31/20

Documentation searched other than minimum documentation to the extent that such documents are included in the fields searched
Jitsuyo Shinan Koho         1922-1996    Jitsuyo Shinan Toroku Koho    1996-2011
Kokai Jitsuyo Shinan Koho   1971-2011    Toroku Jitsuyo Shinan Koho    1994-2011

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | WO 2010/021326 A1 (Lintec Corp.), 25 February 2010 (25.02.2010), claims; paragraphs [0039] to [0049], [0060] to [0063], [0135], [0139] (Family: none) | 1-11 |
| Y | JP 2005-240061 A (Kuraray Co., Ltd.), 08 September 2005 (08.09.2005), paragraphs [0093], [0117] (Family: none) | 1-11 |
| Y | WO 2007/040039 A1 (Toray Industries, Inc.), 12 April 2007 (12.04.2007), paragraphs [0054], [0129], [0144] to [0150] & US 2009/0139564 A1   & EP 1930953 A1 | 1-11 |

| ☒ | Further documents are listed in the continuation of Box C. | ☐ | See patent family annex. |

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 14 April, 2011 (14.04.11) | 26 April, 2011 (26.04.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

22

**INTERNATIONAL SEARCH REPORT**

International application No.

PCT/JP2011/057608

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2008-246893 A  (Lintec Corp.), 16 October 2008 (16.10.2008), entire text (Family: none) | 1-11 |
| A | JP 2006-70238 A  (Lintec Corp.), 16 March 2006 (16.03.2006), entire text (Family: none) | 1-11 |
| A | JP 2007-528447 A  (Exatec L.L.C.), 11 October 2007 (11.10.2007), entire text & US 2005/0202259 A1    & EP 1725699 A | 1-11 |
| A | JP 2008-504687 A  (Varian Semiconductor Equipment Associates, Inc.), 14 February 2008 (14.02.2008), entire text & US 2005/0287307 A1 | 1-11 |

Form PCT/ISA/210 (continuation of second sheet) (July 2009)

**EP 2 554 368 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001119051 A
- JP 2003347570 A
- JP 2004352966 A
- JP 10305542 A
- JP 2007283726 A
- JP 2001026887 A
- JP 2001156013 A